# EUROPEAN PATENT APPLICATION

(11) **EP 1 427 025 A2**
(43) Date of publication of application: **09.06.2004**
(21) Application number: 03078596.8
(22) Date of filing: 18.11.2003
(51) Int. Cl.: H01L 31/052, H01L 31/0224

(54) **A photovoltaic device and a manufacturing method thereof**

(30) Priority: 28.11.2002 GB 0227718
(71) Applicant: EASTMAN KODAK COMPANY, Rochester, New York 14650 (US)
(72) Inventor: Rider, Christopher Barrie, Kodak Limited, Middlesex, HA1 4TY (GB)
(74) Representative: Barker, Brenda

(57) **Abstract**

The invention provides a photovoltaic device, comprising a photovoltaic conversion layer formed from photoactive material. A first electrode is arranged on a first surface of the photovoltaic conversion layer and a second electrode comprising one or more conductive tracks is arranged on the opposite second surface of the photovoltaic conversion layer to receive generated photoelectrons from the photovoltaic conversion layer. A light concentrator is provided adjacent to the second electrode wherein the one or more conductive tracks are arranged in registration with the light concentrator such that incident light is guided substantially through gaps between the one or more conductive tracks. High conductivity of the second electrode is achieved without loss of active area of the device.

## Description

### FIELD OF THE INVENTION

The present invention relates to a photovoltaic device and a manufacturing method thereof.

### BACKGROUND OF THE INVENTION

Photovoltaic devices convert incident light into electrical energy. The most commonly available photovoltaic structure uses a photovoltaic conversion layer of amorphous silicon with sufficient thickness that the device transmits no light. A newer class of photovoltaic devices, fabricated on a transparent support, incorporate a transparent front electrode immediately adjacent the support, with one or more photovoltaic conversion layers situated on the side of the transparent electrode furthest from the support. Within this class, there are several device architectures. Perhaps the best known is the Gratzel Cell as described in Nature, volume 313, page 737 in 1991. The Gratzel Cell is an example of a photoelectrochemical cell. A more recent paper entitled "Photoelectrochemical cells" published in the journal Nature, volume **414**, pages 338 to 344 on 15 November 2001, reviews this type of device.

Other device architectures use only organic components and are referred to as organic solar cells. There are 3 major types of organic cell: single layer, double layer and blends. United States Patent number 4,127,73 8, assigned to Exxon Research entitled, "Photovoltaic device containing an organic layer" is an example of the single layer device. The double layer type is described in "Two-layer organic photovoltaic cell"; C.W. Tang, Appl. Phys. Lett. vol **48**, pp183-185 (1986). An example of the blend type is described in United States Patent number 5,670,791, entitled, "Photoresponsive device with a photoresponsive zone comprising a polymer blend", assigned to U.S. Philips Corporation. Device configurations incorporating conjugated polymers are described in e.g. J. H. Burroughes, et al, Nature, **347** (1990) 183 and G. Yu et al, Science, **270**, 1789 (1995). Various hybrid architectures with dispersed interfaces, incorporating C₆₀ structures or quantum rods of inorganic semiconductors are also known.

A problem with many types of transparent conductive electrode is the compromise between transparency and conductivity. High transparency is required to minimise light losses by allowing as high a proportion of incident light as possible to pass through to the photoactive region. High conductivity is also required to minimise resistive losses as photo-electrons travel from their point of creation in the photoactive region to the interface with the transparent electrode and then through the transparent electrode to an external circuit or load. It is preferred to use a plastic material rather than glass for the transparent support since this reduces manufacturing costs and gives the device greater ruggedness in use. However, the problem of resistive losses is greater when the transparent conductive layer is deposited onto plastic rather than glass since this restricts the choice of materials to those which have the appropriate physical properties and which are compatible with reel to reel manufacturing processes for coating thin layers on plastic

One approach to reducing resistive losses in the transparent electrode is to use a network of narrow opaque tracks of highly conductive material, for example metal, adjacent to the conductive transparent layer. The metallic network or grid is connected to the external circuit. In this way, the photoelectrons only travel a short distance through the transparent conductor before reaching the highly conductive metallic grid. The disadvantage of this approach is that the metallic grid impedes the incident light from reaching the photovoltaic conversion layers and effectively reduces the active area of the photovoltaic cell.

It is well known in the art of image sensor array fabrication, where the photosensitive layer is pixellated, to use a single lens structure associated with each pixel to gather light from an area larger than the active area of the pixel. US Patent number 4694185 assigned to Eastman Kodak Company, describes a method for providing lenses to guide light onto each pixel of a previously fabricated image sensor array.

US patent 6,440,769, assigned to The Trustees of Princeton University, teaches a method for enhancing the light capturing efficiency of a photovoltaic device by fabricating an array of parabolic reflective concentrators on the surface of a photovoltaic device. The optical geometry described overcomes the relatively poor optical absorption of the photovoltaic device by allowing multiple internal reflections and so enabling the incident light to pass several times through it. The probability of absorption of the light by the photovoltaic conversion layers is therefore improved. The design of the concentrating structures draws on concepts presented in *The Optics of Nonimaging Concentrators* by W.T. Welford and R. Winston, 1978, Academic Press Inc., especially Chapter 8 and also in *High Collection Nonimaging Optics,* 1989, by the same authors and publisher, especially pp 172-175.

US patent 5,926,319 assigned to Nashua Corporation, teaches in one embodiment, the use of a microlens screen situated in front of a semiconductor solar cell to concentrate the incident light to a plurality of spots on the semiconductor. The benefit is cited to be, for a given average illumination of the exposed semiconductor surface, a higher electrical output from the device than an arrangement where the same average illumination is provided uniformly across the semiconductor surface.

### PROBLEM TO BE SOLVED BY THE INVENTION

A photovoltaic device is required that has an electrode that is both highly transparent and highly conductive, to achieve high efficiency. A method of manufacturing such a photovoltaic device is also required.

A photovoltaic device is also required that maximises conductivity, whilst minimising any reduction in active area.

### SUMMARY OF THE INVENTION

According to the present invention, there is provided a photovoltaic device, comprising a photovoltaic conversion layer formed from photoactive material. A first electrode is arranged on a first surface of the photovoltaic conversion layer and a second electrode comprising one or more conductive tracks is arranged on the opposite second surface of the photovoltaic conversion layer to receive generated photoelectrons from said photovoltaic conversion layer. A light concentrator is also provided adjacent to the second electrode wherein the one or more conductive tracks are arranged in registration with the light concentrator such that incident light is guided through gaps between the one or more conductive tracks. The light therefore may be received by the photovoltaic conversion layer, even though regions of the photovoltaic conversion layer would be shadowed from incident light by the one or more conductive tracks in conventional devices not incorporating the light concentrator.

According to a second aspect of the present invention, there is provided a method of manufacturing a photovoltaic device, comprising the steps of providing an electrode having one or more conductive tracks on a first surface of a transparent support, the transparent support having a light concentrator arranged on its opposite second surface, the one or more conductive tracks being arranged in registration with the light concentrator, and forming a photovoltaic conversion layer on the first surface of the transparent support, to cover the one or more conductive tracks. An electrode layer is formed on the photovoltaic conversion layer, such that the photovoltaic conversion layer is arranged between the electrode layer and the one or more conductive tracks.

This invention overcomes the problem of loss of active area in photovoltaic devices incorporating a substantially opaque conductive e.g. metallic, network to reduce resistive losses in the transparent electrode. This is achieved by the use of a light concentrator to guide incident light through gaps between the conductive tracks and onto the photovoltaic material. In other words, the light concentrator serves to ensure that incident light avoids the surface of the photovoltaic conversion layer that is covered by the conductive tracks.

The transparent support is provided with a light concentrator such as an array of lenses which act as light concentrating units to concentrate the light on the photovoltaic conversion layer into spots and so direct the light away from individual tracks of the conductive network. The lenses are positioned on the side of the support facing the incident light with the transparent conductive layer on the other side of the support. The focal length of the lenses is approximately equal to the thickness of the support. Light incident on the device is focussed on regions between the one or more conducting tracks. Accordingly, most of the photoactive region is not illuminated assuming point source illumination at infinity (e.g. the sun). The metallic grid may be positioned in these unilluminated regions, without loss of efficiency of the device.

### ADVANTAGEOUS EFFECT OF THE INVENTION

The present invention provides a photovoltaic cell, including a transparent support provided with a light concentrator e.g. an array of lenses which acts to concentrate incident light onto the photovoltaic conversion layer. One or more conductive tracks are provided to improve the conductivity of part of the cell. In contrast to conventional devices where use of such conductive tracks reduces the active area of the device, in the present invention, the light concentrator overcomes this problem by guiding incident light through gaps between conductive tracks and onto the photovoltaic conversion layer. In one example, a grid of highly conductive tracks is used in one of the electrodes of the cell, together with a light concentrator such as a lens array. This enables high conductivity of the electrode to be achieved without loss in active area of the device.

In other words, the present invention overcomes the problem of loss of active area in photovoltaic devices that incorporate metallic or highly conductive grids to reduce resistive losses in one of the device electrodes.

The invention also provides a simple and robust method for manufacturing such a device. The method of manufacture requires the provision of one or more conductive tracks in registration with i.e. in alignment with the lens array. This ensures that when in use the photovoltaic device will operate efficiently with minimal resistive or optical losses.

### BRIEF DESCRIPTION OF THE DRAWINGS

Examples of the present invention will now be described in detail with reference to the accompanying drawings, in which:
Figure 1A shows ray paths through a cross section of an example of a photovoltaic device according to the present invention;
Figure 1B shows a simplified plan view of a photovoltaic device according to the present invention;
Figure 2 shows a cross section of another possible example of a photovoltaic device according to the present invention;
Figures 3A to 3 C show various configurations for a lens array used in the device of the present invention;
Figure 4 shows a step in the manufacture of the device according to the present invention;
Figures 5A to 5C show subsequent steps in the manufacturing process for the device; and,
Figure 5D shows an example of a variant of a network in which there are two thicknesses of tracks to permit a supernetwork of wider tracks for use in the present invention.

### DETAILED DESCRIPTION OF THE INVENTION

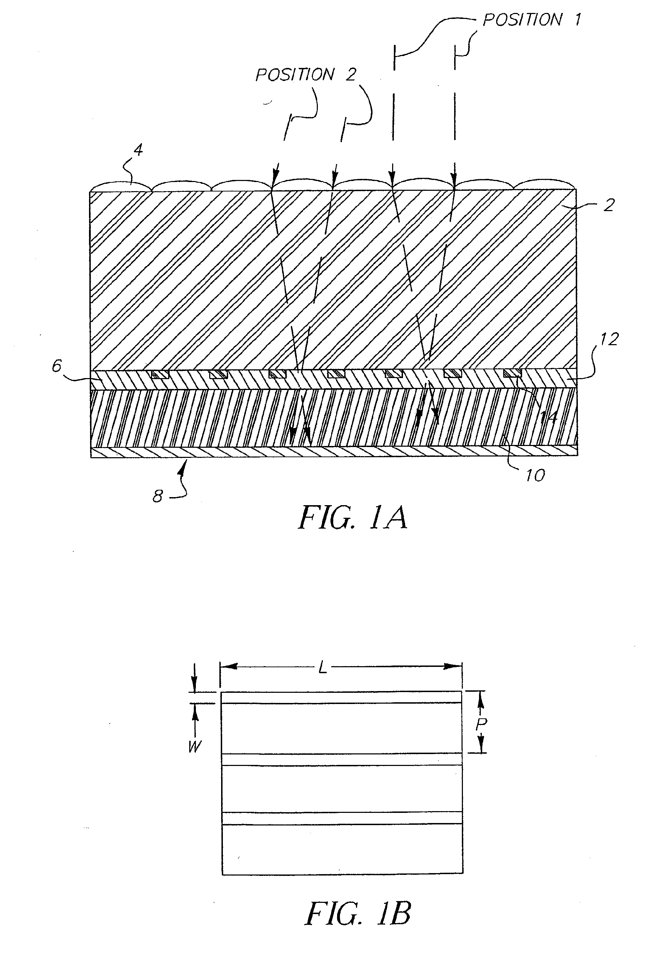

Figure 1A shows ray paths through a cross section of an example of a photovoltaic device according to the present invention with the sun (not shown) in 2 different positions in the sky. The device comprises a light concentrator made up of a transparent support 2 having on one surface one or more (in this example an array 4) light concentrating units employing combinations of refractive, reflective and diffractive units e.g. lenses and mirrors. The array 4 may be integral with the transparent support 2 or may be provided as a separate component of the photovoltaic device. The device also has electrically active components including a photovoltaic conversion layer formed from photoactive material. The electrically active components arranged on the opposite side of the support 2 together perform the photovoltaic conversion of incident light and provide the circuit path for the photogenerated current.

The electrically active components include first and second electrodes 6 and 8 arranged on either side of a continuous i.e. unpixellated photovoltaic conversion layer 10. The required degree of continuity of the photovoltaic conversion layer 10 is such that the photovoltaic conversion layer 10 is isotropic over a region equal in area to more than one of the light concentrating units. Typically, in the case of a close-packed hexagonal arrangement of light concentrating units, the photovoltaic conversion layer 10 is isotropic over a region equal in area to at least seven of the light concentrating units. The photovoltaic conversion layer may in actual fact be formed of more than one layer but will be referred to as the photovoltaic conversion layer hereinafter. In the example shown, the first electrode 6, includes a transparent conductive layer 12 and one or more highly conductive tracks 14 e.g. metallic tracks, to receive generated photoelectrons from the photovoltaic conversion layer, the tracks 14 being in electrical contact with the transparent conductive layer 12. It is preferred that the one or more highly conductive tracks 14 are configured as a network of highly conductive tracks 14.

The conductive tracks may be made of any suitably conductive material. Typically they are made of materials such as metals, alloys, and carbon-based materials e.g. conductive polymers.

The transparent conductive layer may be made from a material such as a transparent conducting oxide e.g. tin oxide, which may or may not be doped with other materials such as indium or fluorine to enhance its conductivity, or a conducting polymer e.g. polythiophene. It is important for the efficient operation of the photovoltaic device to avoid any optical absorption losses of the incident light before photovoltaic conversion takes place. It is therefore preferred that the transmittance of the transparent conductive layer should be at least 50% across the spectral region of interest, preferably greater than 80% and most preferably greater than 90%.

The construction of the photovoltaic conversion layer 10 will depend on the particular photovoltaic device architecture. For organic solar cells, such as the Tang cell, the photovoltaic conversion layers are organic dyes such as copper phthalocyanine and perylene derivatives. For dye-sensitised nanocrystalline cells, such as the Gratzel cell, the photovoltaic conversion layer comprises a mesoporous semiconducting oxide film, typically of sintered titanium dioxide nanocrystals onto which has been formed a monolayer of sensitising dye, typically a ruthenium bipyridyl complex. A liquid electrolyte containing, e.g. an iodide/triiodide redox couple permeates the nanocrystalline structure and fills the space between the two electrodes. In the case of polymeric organic solar cells, polymer layers such as poly-(3-hexylthiophene) or poly (*para*-phenylene vinylene) for example may be used. There are many materials which can be used in the construction of the photovoltaic conversion layer, but the function of the layer is the same: to convert incident light into electrical energy and to channel it to the electrodes. When the device is connected to an external load (not shown), photocurrent flows through the photovoltaic conversion layer into the first electrode 6, in this example into the network of highly conductive tracks 14 via the transparent conductive layer 12. The device is connected to the external load by a connection from the load to the network of tracks 14 at an externally accessible point and by a connection to the second electrode 8.

In position 1, the sun is directly perpendicular to the plane of the photovoltaic device and the sunlight is focussed close to the plane of the highly conductive tracks, midway between two tracks. In position 2, the sun has moved away from the perpendicular and its image now falls much closer to one of the highly conductive tracks.

The network of conductive tracks 14 is located such that light incident from the other side of the support 2 within a wide range of operating angles passes through the gaps in the network on its path to the photovoltaic conversion layer 10 which converts the light to electrical energy. The arrangement of the array 4 relative to the highly conductive tracks serves to substantially increase the active area of the device i.e. the fraction of the total illuminated area that is photoactive. In other words, light incident on the array is substantially all directed through gaps within the network of tracks as opposed to onto the tracks themselves. Therefore, even though a proportion of the photovoltaic conversion layer 10 is obscured by a light absorbing track, since incident light is substantially all focussed onto the photoactive material i.e. exposed regions of the photovoltaic conversion layer which are not obscured by the tracks, there is little if any effect on the device efficiency. In contrast, in conventional photovoltaic devices in which metallic grids are used, the network of highly conductive tracks obscures the photoactive area and reduces the device efficiency.

Furthermore, in the present invention, the network of tracks 14 is configured such that the distance from any point in the photovoltaic conversion layer where a photoelectron may be generated to the nearest track 14 is short compared to the dimensions of the device. This reduces the internal resistive losses of the device in operation compared to conventional devices where there is no network of tracks but just the poorly conducting transparent conductive layer. In cases where no transparent conductive layer is used and the first electrode 6 is formed solely of the highly conductive tracks, the repeating pitch of the network may be finer i.e. the holes in the network are made smaller to further reduce the average distance of travel from any point in the photovoltaic conversion layer to the nearest track, to compensate for any reduction in efficiency of the photovoltaic device.

Figure 1B shows a schematic plan view of part of a linear pattern of conductive tracks. The total area presented by the conductive tracks is 3wl, where w is the track width and 1 is the length of the track. The total area presented by the photovoltaic conversion layer is 3pl where p is the track pitch. The present invention provides a photovoltaic device in which loss of incident light through optical absorption by the grid is substantially avoided. Assuming no light is able to pass through the conductive grid, the fractional optical loss by this mechanism is w/p. In the present invention, substantially all the incident light falling on the device is directed onto the photovoltaic conversion layer.

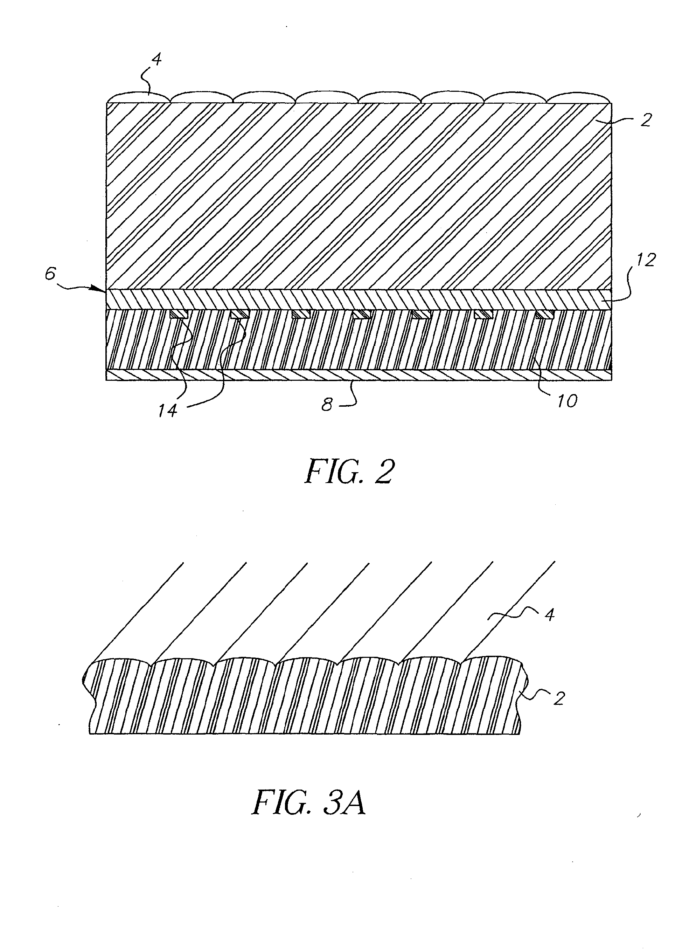

Figure 2 shows a cross section through a second example of a photovoltaic device according to the present invention. As in the example shown in and described above with reference to Figure 1A, a photovoltaic conversion layer 10 is arranged between first and second electrodes 6 and 8. The layer 10 and electrodes 6 and 8 are positioned on the underside of a transparent support 2 having an array 4 of lenses on its upper surface. First electrode 6 is made up of a transparent conductive layer 12 in electrical contact with metal tracks 14. In this case, the metal tracks are formed on the side of the transparent conductive layer 12 furthest from the transparent support 2.

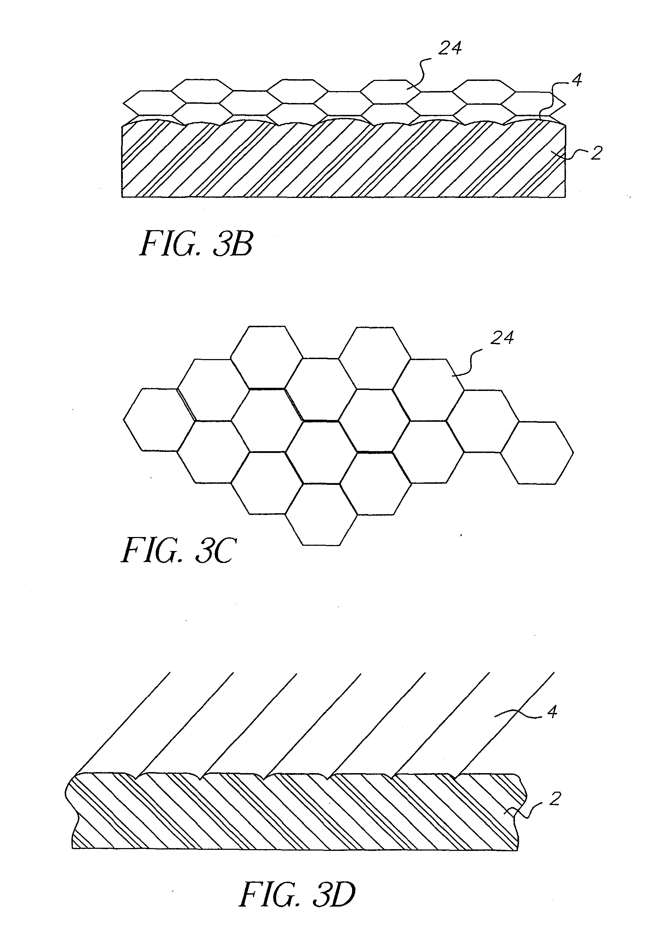

A typical size for each lens may be 50µm to 25mm. The profile of each lens i.e. component in the array 4, may be varied according to the requirements of the intended application. For example, both linear lenticles 4 (cylindrical lenses), as shown in Figure 3A, or a hexagonal close-packed array of lenses 24, as shown in Figure 3B may be used. Figure 3C shows a plan view from above of the hexagonal array of Figure 3B. In the case of solar energy conversion, where the plane of a photovoltaic module e.g. solar panel, incorporating one or more photovoltaic devices according to the present invention, is likely to be kept constant, it is necessary to be able to receive sunlight efficiently from a wide range of angles as the sun moves during the day. In this case, it may be better to use an array of lenses arranged in a hexagonal close-packed array and a conductive track pattern having a corresponding hexagonal network of tracks.

It can be easily demonstrated that for an ideal lens with no aberrations, provided the lens diameter is greater than about twice the focal length of the lens (assuming typical refractive index of 1.5), there will be no possibility of light falling on the conductive tracks. In the case of real lenses, lens aberrations will reduce the efficiency of the systems especially for rays incident at high angles to the plane of the device. The actual profile of each lens can be varied to minimise aberrations and to optimise the system according to the likely operating conditions.

Figure 3D shows an example of a cylindrical lens array where the pitch of the array has been increased but without increasing the depth of the lenticles. This is done by "flattening off" the centre of the profile, since the tracks will be hidden underneath the cusps of the lenticles, not underneath the centre. Such a flattened profile has manufacturing advantages for registration of the track pattern using simple collimated light, but may not be so effective for solar energy capture unless the device is tracked to follow the position of the sun. It may be preferred for other reasons to reduce the variation in thickness of the support material across the lenticle and in this case, a flattened profile may be most suited.

To avoid optical losses of the incident light through absorption by the conductive tracks, it is important to place the opaque conductive tracks 14 outside the illuminated region at the rear surface of the transparent support 2. To achieve the accurate registration of the track pattern, as will be explained below, a manufacturing method using photoresist may be used. Light which exposes the photoresist is controlled to pass through the lens array 4 in a precisely defined manner.

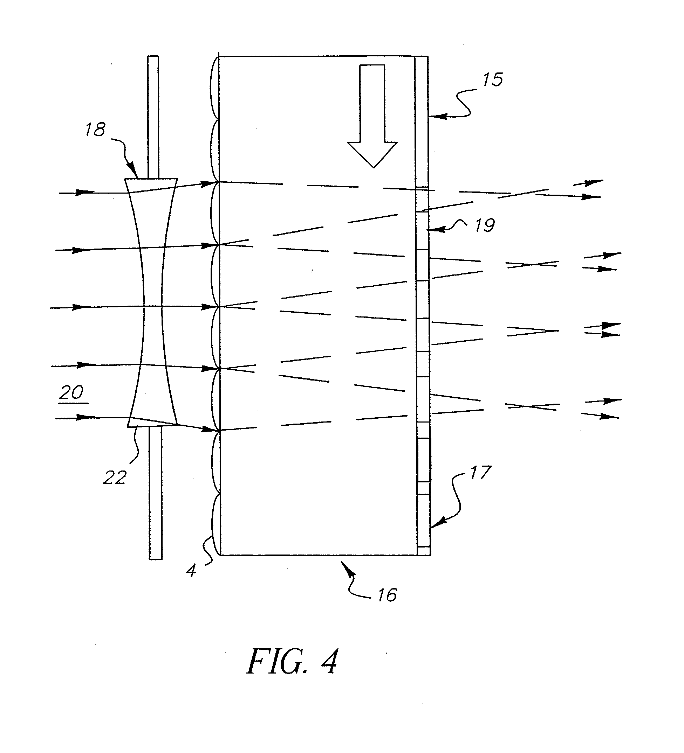

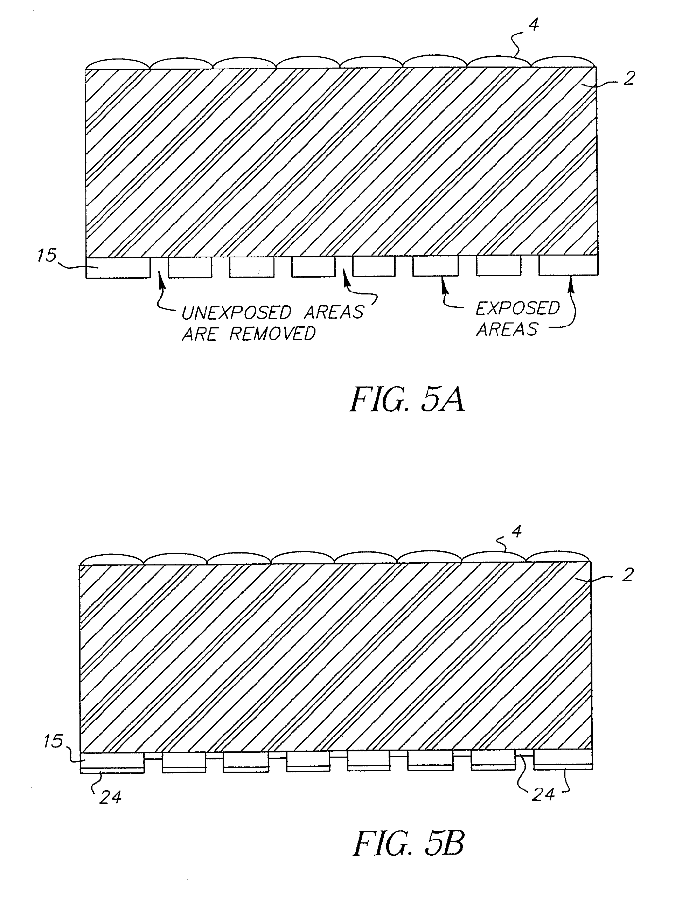

A method of manufacture of the device is now described with reference to Figures 4 and 5A to 5C. First a coated web is formed by coating a layer of photoresist 15 onto the rear surface of the transparent support 2. This may be achieved by passing the transparent support 2 in the form of a moving web 16 through a conventional coating system. There are number of well known coating methods suitable for coating the transparent support 2. Examples include, amongst others, extrusion die coating, roll coating, bead coating, curtain coating and air knife coating.

The coated web 16 is next passed through an illuminated region, in this example a slit 18, illuminated with collimated light, aligned perpendicular to the direction of travel of the web 16 in a plane parallel to it. The light that passes through the slit 18 is incident on the web 16 perpendicular to the plane of the web. Once it has emerged from the slit 18, the light contains a wide range of angles as shown schematically in Figure 4. There are many ways of achieving this, of which the one shown in Figure 4 uses a collimated beam of light 20 falling on a diverging cylindrical lens 22. A cylindrical converging lens would have a similar effect but would be less preferable given the thinness of the support (web 16) and the fact that an image would be formed inside the support. Other options for obtaining light containing a wide range of angles include, for example, a diffuse light source (not shown) placed a distance from the slit 18 in the direction along the perpendicular to the web away from the web to create a naturally divergent beam.

Depending on whether the lens array 4 is formed of lines of cylindrical lenses as shown in Figure 2A or of a two dimensional array of lenses as shown in Figure 2B, the light leaving the slit 18 may be divergent both with respect to the direction of travel of the web and to the direction across the web (not shown).

As the web 16 passes in front of the illuminated slit, the lenses in the array 4 image the light onto the photoresist 15. If parallel light from a distant object falls on the lenses, an image is formed at their focus, which is configured to be in the plane of the photoresist 15. If the illumination falling on the lens array 4 is not at infinity, the image will be formed further away from the lenses. Thus, in the plane of the photoresist, there will be an out of focus image of the light source, which will be larger than the image at the focal plane. As the light source moves closer to the lenses, the patch of light falling on the photoresist 15 will become larger. In Figure 4, the diverging lens 22 is used to create the effect of a source of illumination which is not at infinity and the stronger the negative power of the lens 22, the greater will be the beam divergence of the light which has passed through it.

As the web passes the illuminated region, the image produced by any given lens will appear to move across the photoresist 15 in a direction opposite to the direction of movement of the web itself. The degree of movement is configured so that regions 17 of photoresist exposed by any given lens never touch the regions exposed by adjacent lenses. There is therefore an unexposed region 19 of photoresist located perpendicular to the boundary between adjacent lenses. It is these unexposed regions which form the patterns of the network of tracks 14. Since the photoresist 15 is exposed through the lenses, the pattern formed therein, which after subsequent processing steps will define the conductive network, is inherently aligned with i.e. in registration with the pattern of the lens array 4.

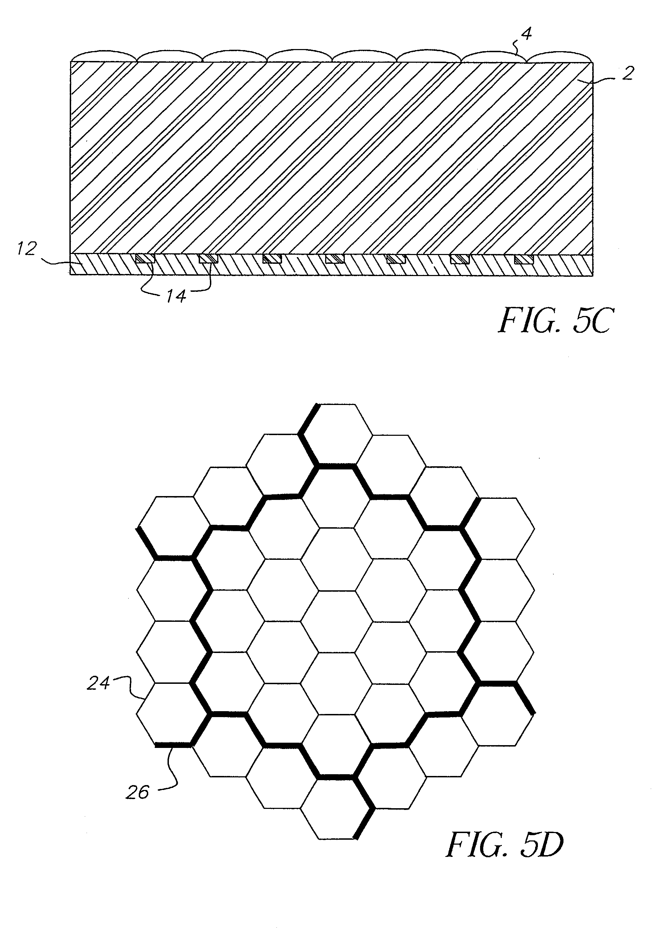

Next, the photoresist 15 is developed to harden the exposed areas and the unexposed areas are removed by washing. Figure 5A shows the remaining resist pattern after development and removal. A layer 24 of highly conductive material, for example copper, silver, gold, aluminium, nickel or any other material with an electrical conductivity of at least 1% of that of copper and with the necessary stability and physical properties for a practical device, is deposited by any convenient method e.g. sputtering, vapour deposition etc onto the patterned photoresist layer as shown in Figure 5B. The conductive layer typically has a thickness in the range 50nm to 5µm, in contrast to the transparent support, and the transparent conductive layer which may have thicknesses in the ranges 50µm to 250µm and 1µm to 10µm, respectively. The final step is to remove the remaining resist pattern from the support using a suitable solvent, and to coat the transparent conductive layer 12, if such a layer is to be included in the device, over the track pattern 14 by any convenient method as shown in Figure 5C.

It may be preferred to coat the transparent conductive layer 12 immediately adjacent the rear surface of the support 2, prior to coating with photoresist. Such a variation in the method would create a device as shown in Figure 2.

The track width is adjusted to be sufficiently thin so that in use, as the sun moves from one extreme position in the sky to the other, its image formed by any given lens focussed at the plane of the track network will not substantially impinge on the tracks 14. On the other hand, the track width and thickness should be sufficiently large to provide a highly conductive path for the photocurrent harvested from the neighboring regions of lower conductivity. Typically the width of the tracks may be within the range 25µm to 250µm. It will be readily appreciated that the width of the tracks are adjusted by the range of angles of incidence of the light used to expose the photoresist as described above with reference to Figure 4. The wider the range of angles, the thinner the tracks will be and vice versa. A further control on the track width may be achieved by adjusting the exposure: more exposure (corresponding to a slower web travel speed or higher brightness illuminant) gives narrower tracks and vice versa. Some control over track width is normally possible in the development process of the resist.

The track thickness required to give reduced resistive losses may be computed from a knowledge of the lens pitch, the range of angles of incidence of the solar energy and the relative resistivities of the deposited metal tracks and the transparent conductive layer. Typically, metal tracks have sheet resistances between 2 and 3 orders of magnitude lower than the best transparent conductive oxide layers of typical thicknesses. For example a 200nm thick layer of copper has a sheet resistance of 0.084 Ω/square whereas a 200nm thick layer of indium tin oxide coated on glass has a typical sheet resistance of between 5 and 15 Ω/square. With transparent conductive polymers the difference can be even greater. For example US patent 6333145 assigned to Agfa teaches a method for preparing a conductive polythiophene layer at low temperatures below 100C. This is to facilitate coatings on plastic webs so that processing after coating does not exceed the glass transition temperature of the plastic support and cause physical damage. Typical values of polythiophene sheet resistance quoted in the patent are around 700 Ω/square.

To enable very large areas of photoactive material to be utilised with minimal resistive losses, it may be advantageous to provide a supernetwork 26 of much wider tracks to harvest the photocurrent from large areas of the fine track network as shown in Figure 5D for a hexagonally packed array of lenses 26. The different track thicknesses are achieved by varying the surface profile of the lenses at their common boundary corresponding to the desired location of the thicker tracks. These lenses may have for example a slightly shorter focal length than their counterparts which are not located near the thicker tracks.

The final steps in the manufacturing process involve the deposition of the photovoltaic conversion layers and the outer electrode. The coated web is then cut into sheets and external contact points are formed to provide electrical contact to the second electrode 8 and the conductive track network within the first electrode 6 and to enable generated electricity to be output from the photovoltaic device.

It is common practice to manufacture photovoltaic devices in small areas, typically in a range from 100 cm² to 10000 cm² and to assemble them into modules of interconnected devices, complete with extra support layers which provide protection from wet and extreme weather conditions. Individual devices may be either connected in series or parallel, depending on the voltage and current output requirements of the module. They may also be assembled in combinations of both series and parallel connections and diode protection may also be required to prevent brightly illuminated devices driving current through partially shadowed devices.

## Claims

1. A photovoltaic device, comprising:
a photovoltaic conversion layer formed from photoactive material;
a first electrode arranged on a first surface of the photovoltaic conversion layer;
a second electrode comprising one or more conductive tracks arranged on the opposite second surface of the photovoltaic conversion layer to receive generated photoelectrons from said photovoltaic conversion layer; and,
a light concentrator adjacent to said second electrode wherein the one or more conductive tracks are arranged in registration with said light concentrator such that incident light is guided substantially through gaps between the one or more conductive tracks.

2. A device according to claim 1, in which the second electrode comprises a transparent conductive layer in electrical communication with said one or more conductive tracks.

3. A device according to claim 2, in which the transparent conductive layer incorporates a metal oxide.

4. A device according to claim 2, in which the transparent conductive layer incorporates a conductive polymer.

5. A device according to claim 1, in which the conductive tracks are made of metal.

6. A device according to claim 1, in which the conductive tracks are made of a carbon-based material.

7. A device according to claim 5, in which the metal is selected from the group consisting of gold, aluminium, nickel, copper, chromium, silver and alloys thereof.

8. A device according to claim 1, in which the light concentrator comprises a transparent support layer having one or more light concentrating units arranged thereon.

9. A device according to claim 1, in which the photovoltaic conversion layer is isotropic over an area which is greater than the area occupied by two light concentrating units.

10. A device according to claim 8, in which the light concentrating units incorporate refractive structures.

11. A device according to claim 8, in which the light concentrating units incorporate diffractive structures.

12. A device according to claim 8, in which the light concentrating units incorporate reflective structures.

13. A device according to claim 1, in which the one or more conductive tracks are connected to form a conductive network.

14. A device according to claim 13, in which the width of the one or more conductive tracks is varied across the device.

15. A device according to claim 8, in which the degree of concentration provided by each of the one or more light concentrating units corresponds to the width of the conductive tracks surrounding the region illuminated by the corresponding light concentrator.

16. A device according to claim 1, further comprising a contact area for each of and in electrical communication with the first and second electrodes for connection to an external circuit.

17. A method of manufacturing a photovoltaic device, comprising the steps of:
providing an electrode comprising one or more conductive tracks on a first surface of a transparent support, the transparent support having a light concentrator arranged on its opposite second surface, the one or more conductive tracks being arranged in registration with the light concentrator;
forming a photovoltaic conversion layer on said first surface of the transparent support, to cover said one or more conductive tracks; and,
forming an electrode layer on said photovoltaic conversion layer, such that the photovoltaic conversion layer is arranged between the electrode layer and the one or more conductive tracks.

18. A method according to claim 17, in which the step of providing one or more conductive tracks on the first surface of the transparent support, comprises:
(a) coating the first surface of the transparent support with a photosensitive material;
(b) exposing said photosensitive material through the light concentrator to define a pattern corresponding to the light concentrator in said photosensitive material;
(c) removing either said photosensitive material exposed to said light or said photosensitive material not exposed to said light;
(d) depositing a thin conductive layer on the resultant photosensitive material structure;
(e) removing said photosensitive material not removed in step (c) together with the thin conductive layer covering said photosensitive material, leaving a layer of thin conductive tracks on said transparent support.

19. A method according to claim 18, in which the photosensitive material is photoresist.

20. A method according to claim 18, in which the photosensitive material is a silver halide photosensitive material.

21. A method according to claim 18, further comprising, between the step of providing one or more conductive tracks, and the step of forming a photovoltaic conversion layer, the step of coating said conductive tracks and the surface on which they are positioned with a material for forming a transparent conductive layer.

22. A method according to claim 18, further comprising, prior to the step of providing one or more conductive tracks, the step of coating said first surface of the transparent support with a material for forming a transparent conductive layer.
